# EUROPÄISCHE PATENTSCHRIFT

(11) **EP 2 029 988 B1**
(45) Veröffentlichungstag und Bekanntmachung des Hinweises auf die Patenterteilung: **05.09.2018**
(21) Anmeldenummer: 07720184.6
(22) Anmeldetag: 11.06.2007
(51) Int. Cl.: G01L 5/00

(54) **QUERKRAFTMESSUNG**
TRANSVERSE FORCE MEASUREMENT
MESURE DE LA FORCE TRANSVERSALE

(30) Priorität: 14.06.2006 CH 973062006
(43) Veröffentlichungstag der Anmeldung: 04.03.2009
(73) Patentinhaber: Kistler Holding AG, 8408 Winterthur (CH)
(72) Erfinder: SCHAFFNER, Georges, 8335 Hittnau (CH); KIRCHHEIM, Andreas, 8422 Pfungen (CH); LEHMANN, Andri, 8488 Turbenthal (CH)
(86) Internationale Anmeldenummer: PCT/CH2007/000287
(87) Internationale Veröffentlichungsnummer: WO 2007/143870

(56) Entgegenhaltungen:
- EP-A- 0 168 313
- DE-A1- 3 146 948
- DE-A1- 4 439 297
- GB-A- 1 537 154

## Beschreibung

### Technisches Gebiet

Die Anmeldung betrifft einen piezoelektrischen Sensor für Biegemoment- oder Drehmomentmessungen mit mindestens einer Achse umfassend mindestens zwei in einer Ebene nebeneinander angeordnete piezoelektrische Plattenteile gemäss den Oberbegriffen der unabhängigen Patentansprüche.

### Stand der Technik

Sensoren für Biegemoment- oder Drehmomentmessungen werden industriell vielerorts verwendet, beispielsweise zur Bestimmung der Kraft eines Kraftübertragungsarms einer Drahtschweisskontaktieranlage, auch Wire-Bonding Anlage genannt.

In der US 6,425,514 wird ein Verfahren dargestellt, in der ein herkömmlicher Kraft- oder Drucksensor zwischen den Schweissarm und die Struktur einer Drahtschweisskontaktieranlage gebracht wird. Anhand der gemessenen Kräfte kann schliesslich rechnerisch auf die Schweisskraft an der Spitze des Schweissarms geschlossen werden.

Der Nachteil einer solchen Vorrichtung besteht darin, dass besser zwei solcher Sensoren eingebaut werden sollten, um die Messgenauigkeit zu erhöhen. Aus Kostengründen wird dies aber in den wenigsten Fällen gemacht.

### Darstellung der Erfindung

Aufgabe der vorliegenden Erfindung ist es, einen Sensor für Biegemoment- oder Drehmomentmessungen anzugeben, welcher eine erhöhte Sensitivität bei vergleichbaren Herstellkosten gegenüber einem herkömmlichen Sensor dieser Art aufweist.

Die Aufgabe wird gelöst durch die Kennzeichen der unabhängigen Patentansprüche.

Die der Erfindung zugrunde liegende Idee besteht darin, ein Messelement in einem piezoelektrischen Sensor für Biegemoment- oder Drehmomentmessungen in seiner Achse messtechnisch zu teilen und beide Hälften mit ihren entgegengesetzten Polarisierungsrichtungen elektrisch zu verbinden. Ein solcher Sensor, eingebaut mit seiner Achse auf der neutralen Biegeachse einer Maschinenstruktur, misst somit gleichzeitig Zug und Druck der Maschinenstruktur auf beiden Seiten seiner Achse. Ein besonderer Vorteil besteht dann, wenn das Messelement einstückig ausgebildet ist und nur die Elektroden auf dem Messelement getrennt sind.

### Kurze Beschreibung der Zeichnungen

Im Folgenden wird die Erfindung unter Beizug der Zeichnungen näher erklärt. Es zeigen
- Fig. 1a: einen Querschnitt durch zwei Plattenteile, angeordnet in entgegengesetzter Orientierungsrichtung, mit Elektroden und deren elektrischen Verbindungen;
- Fig. 1b: einen Querschnitt durch zwei Plattenteile, angeordnet in gleicher Orientierungsrichtung, mit Elektroden und deren elektrischen Verbindungen;
- Fig. 1c: einen Querschnitt durch zwei Plattenteile auf derselben Platte, mit Elektroden und deren elektrischen Verbindungen.
- Fig. 1d: einen Querschnitt durch ein Paar von zwei Plattenteilen, angeordnet in entgegengesetzter Orientierungsrichtung, mit Elektroden und deren elektrischen Verbindungen;
- Fig. 1e: einen Querschnitt durch ein Paar von zwei Plattenteilen, angeordnet in gleicher Orientierungsrichtung, mit Elektroden und deren elektrischen Verbindungen;
- Fig. 1f: einen Querschnitt durch ein Paar von zwei Plattenteilen auf jeweils derselben Platte, mit Elektroden und deren elektrischen Verbindungen;
- Fig. 2: eine Aufsicht eines erfindungsgemässen Sensors mit zwei Plattenteilen;
- Fig. 3: einen Querschnitt einer Maschinenstruktur in Form eines Bond-Armes mit seiner Struktur mit möglichen Positionen für die Montage eines erfindungsgemässen Sensors;
- Fig. 4: eine Frontalansicht einer Maschinenstruktur in Form eines Kraftübertragungsarmes mit seiner Struktur mit einer möglichen Positionen für die Montage eines erfindungsgemässen Sensors;
- Fig. 5a: eine Aufsicht eines erfindungsgemässen Sensors mit vier Plattenteilen;
- Fig. 5b: eine Aufsicht eines anderen erfindungsgemässen Sensors mit vier Plattenteilen;
- Fig. 6a: eine Aufsicht eines anderen erfindungsgemässen Sensors mit zwei Plattenteilen empfindlich auf Schub;
- Fig. 6b: eine Aufsicht eines anderen erfindungsgemässen Sensors mit vier Plattenteilen empfindlich auf Schub.

### Wege zur Ausführung der Erfindung

Die Benennung und Nummerierung ist in allen Figuren für dieselben Komponenten identisch.

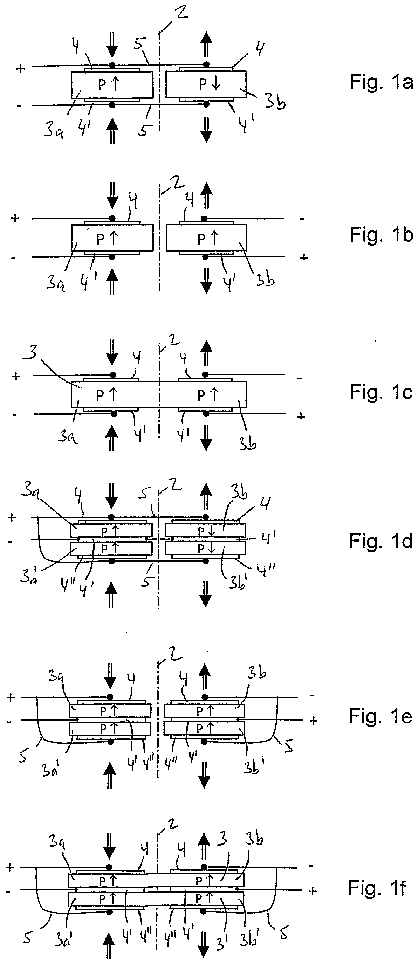

Die Figuren 1a-f zeigen jeweils einen Querschnitt durch mindestens zwei Plattenteile 3a, 3b eines piezoelektrischen Sensors 1 für Biegemoment- oder Drehmomentmessungen. Die Doppelpfeile in den Figuren 1 bezeichnen eine mögliche Kraft- oder Zugeinwirkung auf die Plattenteile, die zu messen ist. Als Plattenteile 3a, 3b werden Teile von Platten verstanden. Diese Plattenteile sind flächig in einer Ebene nebeneinander angeordnet. Als Orientierungsrichtung P wird die Polarisationsrichtung eines Plattenteiles unter Krafteinwirkung verstanden. Diese Richtung ist mit einem einfachen Pfeil und P bezeichnet.

Die Plattenteile 3a, 3b bestehen aus piezoelektrischem Material mit Longitudinaleffekt. Eine Achse 2 des Sensors verläuft zwischen diesen Plattenteilen 3a, 3b. Der Anwendungsbereich eines solchen Sensors 1 ist bestimmt für Biegemoment- oder Drehmomentmessungen mit einer neutralen Biegeachse 9 auf der Achse 2 des Sensors 1. Das zu messende Moment würde demnach durch eine Kraft entstehen, welche entsprechend den eingezeichneten Doppelpfeilen wirkt. Ein solches Moment würde im Plattenteil 3a eine Stauchung und im Plattenteil 3b eine Dehnung verursachen. Die Plattenteile 3a, 3b weisen jeweils beidseitig Elektroden 4, 4' auf, welche bei einer Messung die dort entstandene Ladung sammelt.

Die Elektrode 4 oder 4' des ersten Plattenteils 3a ist mit der Elektrode 4 oder 4' der entgegengesetzten Polarisierung (+, -) des zweiten Plattenteils 3b elektrisch verbunden. Eine solche Verbindung kann im Sensor oder im Auswertegerät zustande kommen.

Elektrische Verbindungen 5 verbinden jeweils die Elektroden 4, 4' mit entgegengesetzten Polarisierungen (+, -) der beiden Plattenteile 3a, 3b, die sich bei einer Messung bilden. Bei identischen Ausgestaltungen und symmetrischen Anordnungen bezüglich der Achse 2 der beiden Hälften verdoppelt sich das Signal dadurch. Die Elektroden 4, 4' können als Metallisierungen auf den piezoelektrischen Plattenteilen oder als eigenständige Komponenten in Form von leitenden Platten ausgestaltet sein.

Die Plattenteile 3a, 3b sind vorgespannt im Sensor angebracht, damit Druck und Zug gemessen werden kann.

In Fig. 1a sind die Plattenteile 3a, 3b in entgegengesetzter Orientierungsrichtung P angeordnet. jede elektrische Verbindung 5 verbindet somit die Elektroden 4 auf derselben Seite der Plattenteile 3a, 3b. In diesem Beispiel können die Elektroden 4, 4' und die elektrischen Verbindungen 5 gemeinsam als jeweils eine leitende Schicht oder Platte ausgestaltet sein.

In der Fig. 1b ist eine Vorrichtung angegeben, die im Gegensatz zur Fig. 1a zwei Plattenteile 3a, 3b aufweist, welche in gleicher Orientierungsrichtung P angeordnet sind. Entsprechend sind die Elektroden 4, 4' nicht auf einer Ebene sondern diagonal miteinander verbunden, mit entgegengesetzten Polarisierungen (+, -). Diese Verbindung ist nicht dargestellt sondern geht lediglich aus den Vorzeichen Plus (+) und minus (-) an den Enden der Elektronischen Verbindungen 5 hervor. Die Enden mit denselben Vorzeichen werden im Sensor oder im Auswertegerät miteinander elektrisch verbunden.

Die Ausführung in der Fig. 1c entspricht weitgehend derjenigen der Fig. 1b, wobei die Plattenteile 3a, 3b in einer Platte 3 einstückig ausgestaltet sind. Dies ist ohne weiteres möglich, da die Orientierungsrichtungen P der Plattenteile 3a, 3b gleich verlaufen. In diesem Ausführungsbeispiel kann die piezoelektrische Platte demnach als Printplatte verwendet werden, auf der die Elektroden als metallisierte Flächen, ähnlich denjenigen von Schalterplatten, aufgetragen sind. Der Vorteil dieser Anordnung besteht darin, dass nur eine Platte bearbeitet und eingebaut werden muss, was die Handhabung vereinfacht.

Die Figuren 1d, 1e und 1f stellen jeweils ein Stapel von Plattenteilen 3a, 3a' und 3b, 3b' dar entsprechend den Ausführungen der Fig. 1a, 1b und 1c. Analog können auch drei und mehr Plattenteile 3a", 3b" stapelweise angeordnet werden. Die Elektroden 4' zwischen den im Stapel anliegende Plattenteilen 3a, 3a' und zwischen den Plattenteilen 3b, 3b' sind vorzugsweise durch Metallisierungen erreicht. Vorzugsweise verbinden die Metallisierungen die angrenzenden Plattenteile miteinander. Diese Verbindung erleichtert die Handhabung der einzelnen Plattenteile.

Die Elektroden 4 sind jeweils mit denen der übernächsten Lagen 4" elektronisch durch elektrische Verbindungen 5 im Sensor oder im Auswertegerät verbunden. Bei mehr als zwei Lagen im Stapel gilt das analog auch.

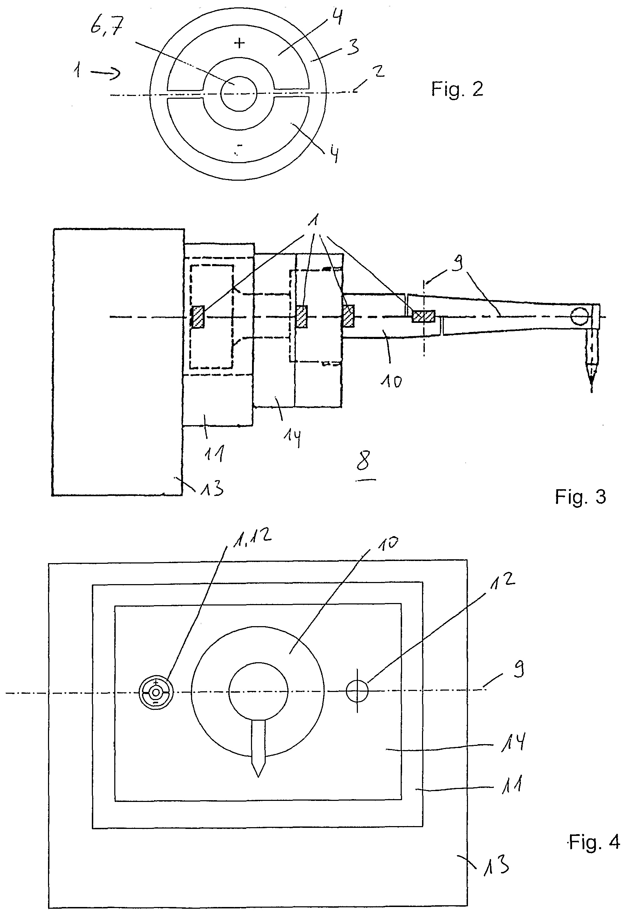

In der Fig. 2 ist eine Aufsicht auf einen erfindungsgemässen Sensor 1 dargestellt entsprechend der Fig. 1c mit einer durchgehenden Platte 3 und zwei Elektroden 4 mit entgegengesetzter Polarisierungen (+, -), die sich bei einer Messung einstellen. Die Elektroden 4 liegen beidseits der Achse 2, welche im eingebauten Zustand auf der neutralen Biegeachse eines Maschinenteils zu liegen hat. Die entsprechenden entgegengesetzten Elektroden 4' mit den entgegengesetzten Polarisierungen liegen auf der Rückseite des Sensors.

Mittig im Sensor ist vorzugsweise eine Befestigungsvorrichtung 6, beispielsweise in Form einer Aussparung 7 vorgesehen zur Durchführung einer Befestigungsschraube oder eines Äquivalent.

Fig. 3 stellt einen Querschnitt einer Maschinenstruktur 8 dar in Form eines Kraftübertragungsarmes 10 mit einer Struktur 11 mit verschiedenen, möglichen Positionen für die Montage eines erfindungsgemässen Sensors 1. Die neutrale Biegachse 9 ist die Fläche in der Maschinenstruktur, in der während einer fachgerechten Beanspruchung der Maschinenstruktur weder eine Dehnung noch eine Stauchung auftritt. Der erfindungsgemässe Sensor 1 kann an einer beliebigen Stelle entlang dieser neutralen Biegeachse 9 angebracht sein, wobei die Achse 2 des Sensors 1 stets in dieser neutralen Biegeachse 9 liegen muss. Somit wirkt sich eine Stauchung einseitig der Achse 2 entgegengesetzt gleich aus wie ein Zug auf deren anderen Seite. Durch die richtige Kombination der Elektroden 4, 4', namentlich durch die Verbindung der entgegengesetzten Polarisierungen der Elektroden 4, 4' beidseits der Achse 2, summieren sich die Signale. Bei symmetrischer Anordnung bedeutet dies eine Verdoppelung.

Erfindungsgemäss kann, wie ebenfalls in der Fig. 3 dargestellt, der Sensor 1 auch in einem eigens dafür angebrachten Schnitt in einem Arm der Maschinenstruktur angebracht sein. Durch die Montage mittig im Sensor durch eine Montageschraube wird diese Montageachse zur neutralen Biegeachse 9 bei einer Belastung am Ende des Arms.

Fig. 4 zeigt dieselbe Anordnung einer Maschinenstruktur wie Fig. 3, jedoch frontal von vorne. Die Struktur 11, angrenzend an einen Aktuator 13, nimmt mittels Befestigung 14 den Kraftübertragungsarm 10 auf. Die neutrale Biegeachse 9 verläuft wie angegeben durch die gesamte Maschinenstruktur 8. Der erfindungsgemässe Sensor 1 kann auch seitlich vom Zentrum, beispielsweise in einem Montagepunkt 12, der auf der neutralen Biegeachse 9 verläuft, angeordnet sein. Der andere Montagepunkt 12 sollte dieselbe Steifigkeit aufweisen wie der Sensor 1, um keine Messfehler zu generieren. Andernfalls kann, zur Erhöhung der Messgenauigkeit, ein zweiter Sensor in einem zweiten Montagepunkt angebracht sein.

Der Vorteil dieses erfindungsgemässen Sensors ist seine einfache Montagemöglichkeit, ohne Prozessstörungen zu verursachen. Zudem ist die Empfindlichkeit durch die Teilung der Elektrode erhöht.

Ein weiterer Vorteil der Erfindung besteht in der Möglichkeit der Auswertung. Werden die Elektroden 4 der einzelnen Plattenteile 3a, 3b nicht im Sensor 1 durch die elektrischen Verbindungen 5 zusammengeführt sondern getrennt zum Auswertegerät oder Verstärker geführt, so lassen sich zusätzliche physikalische Grössen bestimmen. Einerseits kann durch die Summierung der Messwerte rechnerisch das Biegemoment bestimmt werden, das durch die elektrischen Verbindungen 5 zustande gekommen wäre. Andererseits kann durch die Differenzbildung der Messwerte die Kraft bestimmt werden, die auf den Sensor einwirkt. Dies gilt für eine Anordnung der Plattenteile gemäss Fig. 1a, bei den Beispielen gemäss Fig. 1b oder 1c ergeben die Differentbildung das Biegemoment und die Summierung die Kraft.

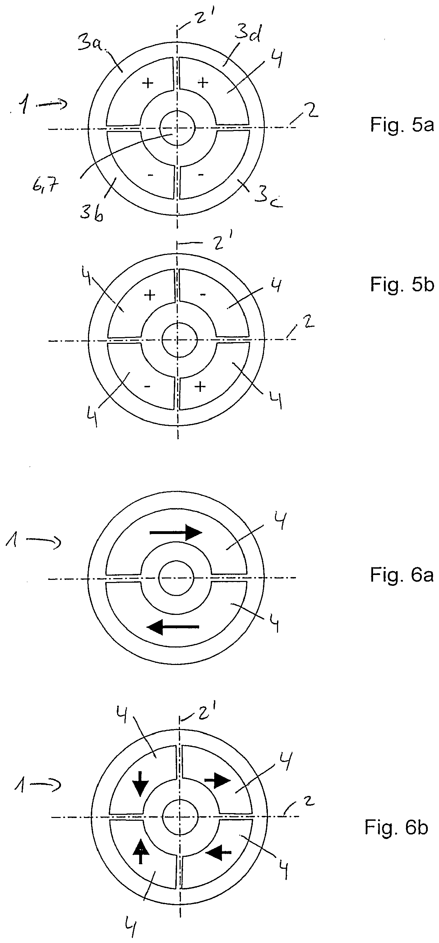

Eine Erweiterung der Erfindung ist in Fig. 5a und 5b dargestellt. Analog zur beschriebenen Ausführung kann der Sensor durch Einführen einer zweiten Achse 2', die senkrecht zur ersten Achse 2 angeordnet ist und die den Sensor in vier Teile teilt, auch mit vier statt zwei Plattenteilen 3a, 3b, 3c, 3d ausgestaltet sein. Ein derart ausgestalteter Sensor lässt Biegungen in beiden Achsen und in der Kombination davon zu. Die Elektroden 4 müssen dafür separat ausgewertet werden. Die Einteilung der Elektroden kann entweder so gewählt werden, dass gleiche Orientierungsrichtungen P diagonal gegenüber, wie in Fig. 5a dargestellt, oder nebeneinander, wie in Fig. 5b dargestellt, zu liegen kommen. Ein Sensor nach Fig. 5 lässt demnach Biegemomente in zwei Richtungen sowie eine Kraftmessung in eine Richtung zu.

Eine weitere Erweiterung der Erfindung ist in Fig. 6a dargestellt. Anstelle von Plattenteilen aus piezoelektrischem Material mit Longitudinaleffekt wird ein Material mit longitudinalem Schereffekt verwendet. Dadurch kann Schub und Drehmoment gleichzeitig gemessen werden, wenn die Signale der Plattenteile separat ausgewertet werden wie in Fig. 5 beschrieben. Analog der in den Fig. 1a bis 1f beschriebenen Art kann auch hier die Platte 3 in Plattenteile 3a, 3b geteilt sein oder die Elektrode 4 getrennt sein und es können mehrere Platten stapelweise verwendet werden.

Fig. 6b zeigt eine Kombination von Schubempfindlichen Platten in verschiedenen Richtungen, welche analog der Beschreibung in Fig. 5 ausgewertet werden kann.

Verschiedene Ebenen mit Plattenteilen verschiedener piezoelektrischer Effekte können in einem Sensor kombiniert werden, sodass eine Vielzahl von' physikalischen Grössen gleichzeitig ermittelt werden kann.

### Bezugszeichenliste

- 1: Sensor
- 2: 2' Achsen
- 3: Platte
3a, 3b, 3c, 3d, 3a', 3b' Plattenteile
4 4' Elektroden
5 Elektrische Verbindungen der Elektroden
6 Befestigungsvorrichtung
7 Aussparung
8 Maschinenstruktur
9 Neutrale Biegeachse
10 Kraftübertragungsarm
11 Struktur
12 Montagepunkt
13 Aktuator
14 Befestigung

## Patentansprüche

1. Piezoelektrischer Sensor (1) für Biegemoment- oder Drehmomentmessungen an einer Maschinenstruktur (8); mit mindestens einer Achse (2); umfassend mindestens zwei in einer Ebene nebeneinander angeordnete piezoelektrische Plattenteile (3a, 3b), welche beidseitig mindestens teilweise mit Elektroden (4, 4') versehen sind und welche beidseitig der Achse (2) unter Vorspannung im piezoelektrischen Sensor (1) angeordnet sind; **dadurch gekennzeichnet, dass** der piezoelektrische Sensor (1) derart in die Maschinenstruktur (8) angebracht wird, dass die Achse (2) auf einer neutralen Biegeachse (9) der Maschinenstruktur (8) liegt; und dass die Elektroden (4, 4') des ersten Plattenteils (3a) mit den Elektroden (4, 4') der entgegen gesetzten Polarisierung des zweiten Plattenteils (3b) elektrisch verbunden sind.

2. Sensor nach Anspruch 1, **dadurch gekennzeichnet, dass** die-Plattenteile (3a, 3b) auf derselben Platte (3) einstückig ausgestaltet sind.

3. Sensor nach einem der vorhergehenden Ansprüche, **dadurch gekennzeichnet, dass** die Plattenteile (3a, 3b) zweistückig ausgestaltet sind.

4. Sensor nach Anspruch 3, **dadurch gekennzeichnet, dass** die Plattenteile (3a, 3b) mit entgegen gesetzter Orientierungsrichtung P im Sensor angeordnet sind.

5. Sensor nach Anspruch 3, **dadurch gekennzeichnet, dass** die Plattenteile (3a, 3b) mit gleicher Orientierungsrichtung P im Sensor angeordnet sind.

6. Sensor nach einem der vorhergehenden Ansprüche, **dadurch gekennzeichnet, dass** die Plattenteile (3a, 3b) identisch sind.

7. Sensor nach einem der vorhergehenden Ansprüche, **dadurch gekennzeichnet, dass** die Plattenteile (31, 3b) symmetrisch bezüglich der Achse (2) angeordnet sind.

8. Sensor nach einem der vorhergehenden Ansprüche, **dadurch gekennzeichnet, dass** mehrere Plattenteile (3a, 3b, 3a', 3b') stapelweise mehrlagig angeordnet und mit Zwischenelektroden (4') ausgestaltet sind, wobei die Elektroden (4) jeweils mit denen der übernächsten Lagen (4") elektronisch verbunden sind (5).

9. Sensor nach Anspruch 8, **dadurch gekennzeichnet, dass** die Zwischenelektroden (4') Metallisierungen sind, welche jeweils im Stapel anliegende Plattenteile (3a, 3a'; 3b, 3b') miteinander verbinden.

10. Sensor nach einem der vorhergehenden Ansprüche, **dadurch gekennzeichnet, dass** die Plattenteile (3a, 3a', 3b, 3b') einen piezoelektrischen Longitudinaleffekt aufweisen zur Bestimmung eines Biegemomentes um die Achse 2 oder einen piezoelektrischen longitudinalen Schereffekt zur Bestimmung eines Drehmomentes um eine zentrale Drehachse senkrecht zur Plattenebene.

11. Sensor nach einem der Ansprüche 2 bis 10, mit einer zweiten Achse (2') senkrecht zur ersten Achse (2), **gekennzeichnet durch** mindestens vier identische piezoelektrische Plattenteile (3a, 3b, 3c, 3d) der beschriebenen Art, welche symmetrisch, in jedem der durch die Achsen (2, 2') definierte vier Segmente des Sensors angeordnet sind, wobei die Elektroden (4, 4') elektrisch getrennt voneinander zu einer Auswerteeinheit geführt sind zur einzelnen Messwertbestimmung jedes Plattenteils (3a, 3b, 3c, 3d) für die Bestimmung der Biegemomentmessung bezüglich beiden Achsen (2, 2') oder der Drehmomentmessung.

12. Sensor nach Anspruch 11, **dadurch gekennzeichnet, dass** die Plattenteile (3a, 3b, 3c, 3d) einzeln ausgestaltet sind; und dass die einzelnen Plattenteile (3a, 3b, 3c, 3d) derart ausgewählt sind, dass eine Biegemoment- oder Drehmomentmessungen sowie Schubkräfte in zwei Richtungen gemessen werden können.

13. Anwendung eines Sensors nach einem der vorhergehenden Ansprüche zur indirekten Biegemoment- oder Drehmomentmessungen einer Maschinenstruktur (8), **dadurch gekennzeichnet, dass** der Sensor derart an der Maschinenstruktur (8) angebracht ist, dass die Achse (2) des Sensor auf der Biegeachse (9) der Maschinenstruktur (8) liegt.

14. Anwendung nach Anspruch 13, **dadurch gekennzeichnet, dass** die Maschinenstruktur (8) eine elektrische Drahtschweisskontaktieranlage ist umfassend einen Kraftübertragungsarm (10) an einer Struktur (11); und dass der Sensor im Kraftübertragungsarm (10) angeordnet ist.

15. Anwendung nach Anspruch 14, **dadurch gekennzeichnet, dass** mindestens ein Sensor in einem der Montagepunkte (12) angeordnet ist, welcher den Kraftübertragungsarm (10) mit der Struktur (11) der Drahtschweisskontaktieranlage verbindet.

## Claims

1. A piezoelectric sensor (1) for the measurement of bending moment or torque at a machine structure (8); having at least one axis (2); comprising at least two piezoelectric plate elements (3a, 3b) arranged side by side to one another in a plane and being provided on both sides at least partially with electrodes (4, 4') and placed on both sides of said axis (2) under prestress within the piezoelectric sensor (1), **characterized in that** the piezoelectric sensor (1) is positioned in the machine structure (8) such that the axis (2) lies on a neutral bending axis of said machine structure (8); and the electrodes (4, 4') of the first plate element (3a) are electrically connected to the electrodes with opposite polarization of the second plate element (3b).

2. The sensor according to claim 1, **characterized in that** the plate elements (3a, 3b) on the same plate (3) are formed as one piece.

3. The sensor according to any of the preceding claims, **characterized in that** the plate elements (3a, 3b) are formed as two parts.

4. The sensor according to claim 3, **characterized in that** the plate elements (3a, 3b) are arranged in the sensor with opposite directions of orientation P.

5. The sensor according to claim 3, **characterized in that** the plate elements (3a, 3b) are arranged in the sensor with the same directions of orientation P.

6. The sensor according to any of the preceding claims, **characterized in that** the plate elements (3a, 3b) are identical.

7. The sensor according to any of the preceding claims, **characterized in that** the plate elements (31, 3b) are arranged symmetrically with respect to the axis (2).

8. The sensor according to any of the preceding claims, **characterized in that** multiple plate elements (3a, 3b, 3a', 3b') are stacked in multiple layers and provided with intermediate electrodes (4') wherein said electrodes (4) are each electronically connected (5) to those of the next but one layers (4").

9. The sensor according to claim 8, **characterized in that** said intermediate electrodes (4') are metallizations each connecting plate elements (3a, 3a'; 3b, 3b') that lie adjacent to each other in the stack.

10. The sensor according to any of the preceding claims, **characterized in that** the plate elements (3a, 3a', 3b, 3b') show a piezoelectric longitudinal effect for determining a bending moment around the axis (2) or show a piezoelectric longitudinal shear effect for determining a torque around a central rotation axis perpendicular to the plane of the plate.

11. The sensor according to any of claims 2 to 10 having a second axis (2') perpendicular to the first axis (2), **characterized by** at least four identical piezoelectric plate elements (3a, 3b, 3c, 3d) of the type described, which are arranged symmetrically in each of four segments of the sensor defined by the axes (2, 2') wherein said electrodes (4, 4') are connected to an evaluation unit in an electrically separate manner to enable determination of the individual measuring values of each plate element (3a, 3b, 3c, 3d) for performing the bending moment measurement with respect to both axes (2, 2'), or the torque measurement.

12. The sensor according to claim 11, **characterized in that** the plate elements (3a, 3b, 3c, 3d) are formed individually, and **in that** the individual plate elements (3a, 3b, 3c, 3d) are chosen in a way that bending moment or torque measurements as well as shear forces can be measured in two directions.

13. A use of a sensor according to any of the preceding claims for indirect bending moment or torque measurements of a machine structure (8), **characterized in that** the sensor is attached to the machine structure (8) such that the axis (2) of the sensor lies on the bending axis (9) of the machine structure.

14. The use according to claim 13, **characterized in that** the machine structure (8) is an electrical wire welding contacting machine comprising a force transmission arm (10) on a structure (11); and **in that** the sensor is arranged in said force transmission arm (10).

15. The use according to claim 14, **characterized in that** at least one sensor is arranged in one of the assembly points (12) connecting the force transmission arm (10) to the structure (11) of the wire welding contacting machine.

## Revendications

1. Capteur piézoélectrique (1) pour des mesures de moment de flexion ou de couple sur une structure de machine (8); comportant au moins un axe (2); comprenant une plaque piézoélectrique en au moins deux parties (3a, 3b) disposées l'une à côté de l'autre dans un plan, munies des deux côtés au moins partiellement avec des électrodes (4, 4') et disposées de part et d'autre dudit axe (2) avec précontrainte dans le capteur piézoélectrique (1), **caractérisé en ce que** le capteur piézoélectrique (1) est positionné dans la structure de machine (8) d'une telle manière que l'axe (2) se situe sur un axe neutre de flexion de la structure de machine (8); et lesdits électrodes (4, 4') de la première partie de plaque (3a) sont reliés électriquement aux électrodes ayant une polarisation opposée de la seconde partie de plaque (3b).

2. Capteur selon la revendication 1, **caractérisé en ce que** les parties de plaque (3a, 3b) sur la même plaque (3) sont formées d'une seule pièce.

3. Capteur selon l'une quelconque des revendications précédentes, **caractérisé en ce que** les parties de plaque (3a, 3b) sont en forme de deux parties.

4. Capteur selon la revendication 3, **caractérisé en ce que** les parties de plaque (3a, 3b) sont disposées au sein du capteur avec leur direction d'orientation P opposée.

5. Capteur selon la revendication 3, **caractérisé en ce que** les parties de plaque (3a, 3b) sont disposées au sein du capteur avec la même direction d'orientation P.

6. Capteur selon l'une quelconque des revendications précédentes, **caractérisé en ce que** les parties de plaque (3a, 3b) sont identiques.

7. Capteur selon l'une quelconque des revendications précédentes, **caractérisé en ce que** les parties de plaque (31, 3b) sont disposées symétriquement par rapport à l'axe (2).

8. Capteur selon l'une quelconque des revendications précédentes, **caractérisé en ce que** plusieurs parties de plaque (3a, 3b, 3a', 3b') sont empilées en plusieurs couches et munies d'électrodes intermédiaires (4'), chacune desdites électrodes (4) étant reliée électroniquement (5) à celles de la deuxième couche suivante (4").

9. Capteur selon la revendication 8, **caractérisé en ce que** lesdites électrodes intermédiaires (4') sont métallisations chacune d'elles connectant les parties de plaque (3a, 3a'; 3b, 3b') adjacentes les unes aux autres dans la pile.

10. Capteur selon l'une quelconque des revendications précédentes, **caractérisé en ce que** les parties de plaque (3a, 3a', 3b, 3b') ont un effet longitudinal piézoélectrique pour déterminer un moment de flexion autour de l'axe (2) ou ont un effet de cisaillement longitudinal piézoélectrique pour déterminer un couple autour un axe de rotation central perpendiculaire au plan de la plaque.

11. Capteur selon l'une quelconque des revendications 2 à 10 ayant un second axe (2') perpendiculaire au premier axe (2), **caractérisé en ce qu'**il comprend au moins quatre parties de plaque piézoélectrique (3a, 3b, 3c, 3d) identiques du type décrit disposées symétriquement dans chacun des quatre segments du capteur définis par les axes (2, 2'), lesdites électrodes (4, 4') étant reliées à un analyseur de manière électriquement séparées permettant de déterminer les valeurs de mesure individuelles de chacune partie de plaque (3a, 3b, 3c, 3d) pour effectuer la mesure du moment de flexion par rapport aux deux axes (2, 2'), ou la mesure du couple.

12. Capteur selon la revendication 11, **caractérisé en ce que** les parties de plaque (3a, 3b, 3c, 3d) sont formées individuellement et **en ce que** lesdites parties de plaque (3a, 3b, 3c, 3d) individuelles sont choisies de telle manière qu'elles permettent des mesures de moment de flexion ou de couple ainsi que de forces de cisaillement dans deux directions.

13. Utilisation d'un capteur selon l'une quelconque des revendications précédentes pour mesurer indirectement un moment de flexion ou un couple d'une structure de machine (8), **caractérisé en ce que** ledit capteur est fixé à la structure de machine (8) d'une telle manière que l'axe (2) du capteur se situe sur l'axe de flexion (9) de la structure de machine.

14. Utilisation selon la revendication 13, **caractérisé en ce que** la structure de machine (8) est un système de contact pour soudage par fil électrique comprenant un bras de transmission des forces (10) sur une structure (11); et **en ce que** ledit capteur est disposé dans ledit bras de transmission des forces (10).

15. Utilisation selon la revendication 14, **caractérisé en ce qu'**au moins un capteur est disposé à l'un des points de montage (12) connectant ledit bras de transmission des forces (10) à la structure (11) du système de contact pour soudage par fil électrique.
